(19) Europäisches Patentamt
European Patent Office
Office européen des brevets

(11) **EP 2 312 851 A2**

(12) **EUROPEAN PATENT APPLICATION**
published in accordance with Art. 153(4) EPC

(43) Date of publication:
**20.04.2011 Bulletin 2011/16**

(51) Int Cl.:
**H04N 7/24** *(2011.01)*

(21) Application number: **09794678.4**

(22) Date of filing: **13.07.2009**

(86) International application number:
**PCT/KR2009/003831**

(87) International publication number:
**WO 2010/005272 (14.01.2010 Gazette 2010/02)**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**
Designated Extension States:
**AL BA RS**

(30) Priority: **11.07.2008 KR 20080067815**

(71) Applicant: **Samsung Electronics Co., Ltd.**
**Suwon-si, Gyeonggi-do 442-742 (KR)**

(72) Inventors:
• **KIM, Jung-Hoe**
**Yongin-si**
**Gyeonggi-do 446-712 (KR)**

• **CHOO, Ki-Hyun**
**Yongin-si**
**Gyeonggi-do 446-712 (KR)**
• **YURKOV, Kirill**
**St.Petersburg 197101 (RU)**
• **KUDRYASHOV, Boris**
**St.Petersburg 197101 (RU)**

(74) Representative: **D'Halleweyn, Nele Veerle Trees**
**Gertrudis**
**Arnold & Siedsma**
**Sweelinckplein 1**
**2517 GK The Hague (NL)**

(54) **METHOD AND APPARATUS FOR MULTI-CHANNEL ENCODING AND DECODING**

(57)    Embodiments of the present invention provide a method and an apparatus for encoding and decoding a multi-channel signal by discarding duplicate information among multiple channels and encoding and decoding the residual signal, without using a downmix signal. The present invention encodes and decodes: a reference signal from multiple channel signals constituting a multi-channel signal; a phase difference between each of the multiple channel signals and the reference signal; a gain which is a ratio of each of the multiple channel signals to the reference signal; and a residual signal which is an error between an actual channel signal and a channel signal predicted by applying the phase difference and the gain to the reference signal.

FIG. 4

```
            START
400 —    DEMULTIPLEXING
410 —    LOSSLESS DECODING
420 —    INVERSE QUANTIZATION OF THE REFERENCE SPECTRUM
425 —    INVERSE TRANSFORMATION OF THE REFERENCE
              SPECTRUM TO TIME DOMAIN
427        ARE THESE
        INDIVIDUALLY ENCODED MULTI-        YES
           CHANNEL SIGNALS?
              NO                                      455
430 —  TRANSFORMATION OF A REFERENCE SIGNAL    QUANTIZATION OF A
           TO A FREQUENCY DOMAIN                CHANNEL SPECTRUM
435 —  INVERSE QUANTIZATION OF A PHASE DIFFERENCE
440 —    INVERSE QUANTIZATION OF A GAIN
445 —  INVERSE QUANTIZATION OF A RESIDUAL SPECTRUM
450 —  RESTORATION OF A CHANNEL SPECTRUM BY
          APPLYING THE PHASE DIFFERENCE.
        GAIN, AND RESIDEUAL SPECTRUM TO THE
              REFERENCE SPECTRUM
460 —  INVERSE TRANSFORMATION OF THE CHANNEL
            SPECTRUM TO A TIME DOMAIN
470 —    OUTPUT OF THE MULTI-CHANNEL SIGNAL
            END
```

EP 2 312 851 A2

**Description**

Technical Field

One or more embodiments relate to a method and apparatus for encoding and decoding an audio signal and/or a speech signal, and more particularly, to a method and apparatus for encoding and decoding a multi-channel signal having a plurality of channels.

Background Art

In general, methods of encoding a multi-channel signal are categorized into waveform encoding and a parametric encoding. In parametric encoding, a multi-channel image is formed by transmitting a spatial cue at a low bit rate. Parametric encoding is generally performed at about 40 kbps or less, with a down-mixing process being performed on a multi-channel signal. Spatial cues are extracted during the down-mixing process and are expressed in the form of inter-channel energy or level differences, inter-channel signal similarity, or inter-channel phase differences, to encode the multi-channel signal. Motion picture experts group (MPEG) surround coding and binaural cue coding are representative examples of the parametric encoding. However, such encoding techniques are not capable of precisely expressing reverberations, and thus, it is difficult to recover the original sounds even if the encoding bit rate is increased.

Description of Drawings

FIG. 1 illustrates a multi-channel encoding apparatus, according to one or more embodiments;
FIG. 2 illustrates a multi-channel decoding apparatus, according to one or more embodiments;
FIG. 3 illustrates a multi-channel encoding method, according to one or more embodiments; and
FIG. 4 illustrates a multi-channel decoding method, according to one or more embodiments.

Disclosure

Technical Problem

One or more embodiments include a multi-channel encoding and decoding method and apparatus capable of encoding and decoding residual signals by removing redundant information between a plurality of channels without a need for a downmixed signal.

Technical Solution

According to one or more embodiments, there is provided a multi-channel encoding apparatus including a reference signal encoding unit to select a reference signal from among a plurality of channel signals in a multi-channel signal and to encode the reference signal, a phase difference encoding unit to calculate and encode respective phase differences between a remainder of the plurality of channel signals and the reference signal, a gain encoding unit to calculate and encode respective gains of the remainder of the plurality of channel signals, with the respective gains being ratios of respective amplitudes of the remainder of the plurality of channel signals to an amplitude of the reference signal, and a residual signal encoding unit to extract and encode respective residual signals corresponding to differences between each predicted signal and each corresponding channel signal of the remainder of the plurality of channel signals, where each predicted signal is predicted by respectively applying a respective calculated phase difference and a respective calculated gain to the reference signal for each corresponding channel signal of the remainder of the plurality of channel signals.

According to one or more embodiments, there is provided a multi-channel decoding apparatus including a reference signal decoding unit to decode a reference signal, from among a plurality of channel signals, for a multi-channel signal, a phase difference decoding unit to decode respective phase differences between remainder channel signals of the plurality of channel signals and the reference signal, with the remainder of the plurality of channel signals including the plurality of channel signals without the reference signal, a gain decoding unit to decode respective gains of the remainder of the plurality of channel signals as ratios of respective amplitudes of the remainder of the plurality of channel signals to an amplitude of the reference signal, a residual signal decoding unit to decode respective residual signals corresponding to encoder determined differences between each predicted signal and each corresponding channel signal of the remainder of the plurality of channel signals, with each predicted signal being predicted by respectively applying an encoder calculated phase difference and an encoder calculated gain to the reference signal during an encoding of the multi-channel signal, and a multi-channel reconstruction unit to reconstruct the remainder of the plurality of channel signals by using the respective phase differences, respective gains, and respective residual signals.

According to one or more embodiments, there is provided a multi-channel encoding method including selecting and encoding a reference signal from among a plurality of channel signals in a multi-channel signal, calculating and encoding respective phase differences between a remainder of the plurality of channel signals and the reference signal, calculating and encoding respective gains of the remainder of the plurality of channel signals, with the respective gains being ratios of respective amplitudes of the remainder of the plurality of channel signals to an amplitude of the reference signal, and extracting and encoding respective residual signals corresponding to differences between each predicted signal and each corresponding channel signal of the remainder of the plurality of channel signals, where each predicted signal is predicted by respectively applying a respective calculated phase difference and a respective calculated gain to the reference signal for each corresponding channel signal of the remainder of the plurality of channel signals.

According to one or more embodiments, there is provided a multi-channel decoding method including decoding a reference signal, from among a plurality of channel signals, for a multi-channel signal, decoding respective phase differences between remainder channel signals of the plurality of channel signals and the reference signal, with the remainder of the plurality of channel signals including the plurality of channel signals without the reference signal, decoding respective gains of the remainder of the plurality of channel signals as ratios of respective amplitudes of the remainder of the plurality of channel signals to an amplitude of the reference signal, decoding respective residual signals corresponding to encoder determined differences between each predicted signal and each corresponding channel signal of the remainder of the plurality of channel signals, with each predicted signal being predicted by respectively applying a calculated phase difference and a calculated gain to the reference signal during an encoding of the multi-channel signal, and reconstructing the remainder of the plurality of channel signals by using the respective phase differences, respective gains, and respective residual signals.

According to one or more embodiments, there is provided a computer readable recording medium having recorded thereon a computer program to control at least one processing device to implement a multi-channel encoding method, the method including selecting and encoding a reference signal from among a plurality of channel signals in a multi-channel signal, calculating and encoding respective phase differences between a remainder of the plurality of channel signals and the reference signal, calculating and encoding respective gains of the remainder of the plurality of channel signals, with the respective gains being ratios of respective amplitudes of the remainder of the plurality of channel signals to an amplitude of the reference signal, and extracting and encoding respective residual signals corresponding to differences between each predicted signal and each corresponding channel signal of the remainder of the plurality of channel signals, where each predicted signal is predicted by respectively applying a respective calculated phase difference and a respective calculated gain to the reference signal for each corresponding channel signal of the remainder of the plurality of channel signals.

According to one or more embodiments, there is provided a computer readable recording medium having recorded thereon a computer program to control at least one processing device to implement a multi-channel decoding method, the method including decoding a reference signal, from among a plurality of channel signals, for a multi-channel signal, decoding respective phase differences between remainder channel signals of the plurality of channel signals and the reference signal, with the remainder of the plurality of channel signals including the plurality of channel signals without the reference signal, decoding respective gains of the remainder of the plurality of channel signals as ratios of respective amplitudes of the remainder of the plurality of channel signals to an amplitude of the reference signal, decoding respective residual signals corresponding to encoder determined differences between each predicted signal and each corresponding channel signal of the remainder of the plurality of channel signals, with each predicted signal being predicted by respectively applying an encoder calculated phase difference and an encoder calculated gain to the reference signal during an encoding of the multi-channel signal, and reconstructing the remainder of the plurality of channel signals by using the respective phase differences, respective gains, and respective residual signals.

Mode for invention

Reference will now be made in detail to embodiments, examples of which are illustrated in the accompanying drawings, wherein like reference numerals refer to the like elements throughout. In this regard, the present embodiments may have different forms and should not be construed as being limited to the descriptions set forth herein. Accordingly, the embodiments are merely described below, by referring to the figures, to explain aspects of the present description.

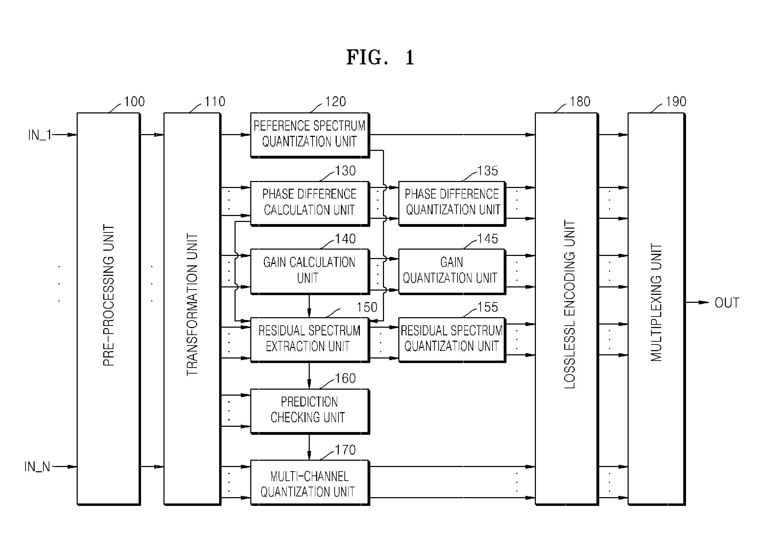

FIG. 1 illustrates a multi-channel encoding apparatus, according to one or more embodiments. Referring to FIG. 1, the multi-channel encoding apparatus may include a pre-processing unit 100, a transformation unit 110, a reference spectrum quantization unit 120, a phase difference calculation unit 130, a phase difference quantization unit 135, a gain calculation unit 140, a gain quantization unit 145, a residual spectrum extraction unit 150, a residual spectrum quantization unit 155, a prediction checking unit 160, a multi-channel quantization unit 170, a losslessly encoding unit 180 and a multiplexing unit 190, for example. Here, one or more of the pre-processing unit 100, the transformation unit 110, the reference spectrum quantization unit 120, the phase difference calculation unit 130, the phase difference quantization unit 135, the gain calculation unit 140, the gain quantization unit 145, the residual spectrum extraction unit 150, the residual spectrum quantization unit 155, the prediction checking unit 160, the multi-channel quantization unit 170, the losslessly encoding unit 180 and the multiplexing unit 190 may be implemented or integrated as at least one processor or processing device, for example.

The pre-processing unit 100 receives a multi-channel signal having N-channel signals via input terminals IN_ 1 to IN_N, and selects a reference signal, to be used as a reference for encoding, from among the N-channel signals. The pre-processing unit 100 may select the reference signal from among the N-channel signals but may also generate a reference signal in various ways. For example, if the multi-channel signal includes two-channel signals, the pre-processing unit 100 may select or generate the reference signal based on at least one matrix operation among the matrices expressed in the below Equation 1, for example. That is, if the multi-channel signal comprises the N-channel signals, the reference signal is generated or selected to minimize residual signals, by means of an operation of the N-channel signal and respective matrices.

Equation 1:

$$\begin{bmatrix} 1 & 0 \\ 0 & 1 \end{bmatrix}, \begin{bmatrix} 0 & 1 \\ 1 & 0 \end{bmatrix} \ and \ \begin{bmatrix} 1 & 1 \\ -1 & 1 \end{bmatrix}$$

The pre-processing unit 100 may also change the reference signal in units of bark bands selected or generated from among the N-channel signals, noting that alternative techniques for choosing a reference signal are equally available. If the number of channels included in the multi-channel signal increases or if necessary, a plurality of reference signals may be used.

Alternatively, the multi-channel encoding apparatus may not implement or include the pre-processing unit 100.

The transformation unit 110 may generate a multi-channel spectrum by transforming the multi-channel signal from the time domain to the frequency domain so that the amplitudes and phases of the N-channel signals are expressed. For example, the transformation unit 110 may express each of the N-channel signals in the form of a complex-valued spectrum by performing a complex-valued transformation. When the complex-valued transformation is used, the transformation unit 110 calculates a real-number part and imaginary-number part by respectively performing a modified discrete cosine transformation (MDCT) and modified discrete sine transformation (MDST), for example, on the multi-channel signal in the time domain.

For example, when the multi-channel signal includes two-channel signals, e.g., a stereo signal, the transformation unit 110 may respectively transform the left signal and the right signal into x(t) and y(t) spectrums, as shown in the below Equation 2, for example.

Equation 2:

$$x(t) = a_0(t) e^{i\varphi_0(t)}$$

$$y(t) = a_1(t) e^{i\varphi_1(t)}$$

Here, x(t) denotes a spectrum being obtained by transforming the left signal (first channel signal) by the transformation unit 110, y(t) denotes a spectrum being obtained by transforming the right signal (second channel signal) by the transformation unit 110, $a_i(t)$ denotes the amplitude of an $i^{th}$ channel spectrum, and $\varphi_i(t)$ denotes the phase of the $i^{th}$ channel spectrum.

The reference spectrum quantization unit 120 may quantize a reference spectrum being obtained by selecting the reference signal from among the N-channel signals by the pre-processing unit 100 and transforming the reference signal by the transformation unit 110. If the transformation unit 110 performs complex-valued transformation using MDCT and MDST, as only an example, the reference spectrum quantization unit 120 may quantize only a reference spectrum obtained using MDCT. In addition, the reference spectrum quantization unit 120 may quantize the reference spectrum by controlling the encoded amount of bits by determining quantization step size based on a psychoacoustic model.

The phase difference calculation unit may 130 calculate the phase differences between the respective channel spectrums and the reference spectrum. For example, the phase difference calculation unit 130 may calculate the phase differences according to the below Equation 3, for example.

Equation 3:

$$\psi_i = \varphi_s(t) - \varphi_i(t)$$

Here, $\psi_i$ denotes the phase differences between the $i^{th}$ channel spectrum and the reference spectrum, $\varphi_s(t)$ denotes the phase of the reference spectrum, and $\varphi_i(t)$ denotes the phase of the $i^{th}$ channel spectrum.

The gain calculation unit 140 may calculate respective gains, as respective ratios of the amplitudes of the channel spectrums to the amplitude of the reference spectrum. For example, the gain calculation unit 140 may calculate the gains according to the below Equation 4, for example.

Equation 4:

$$g_i = \frac{a_s}{a_l}$$

Here, $g_i$ denotes the gain of the $i^{th}$ channel spectrum, $a_s$ denotes the amplitude of the reference spectrum, and $a_i$ denotes the amplitude of the $i^{th}$ channel spectrum.

The calculation of the phase differences between the respective channel spectrums and the reference spectrum, e.g., by the phase difference calculation unit 130, and the calculation of the gains of the respective channel spectrums, e.g., by the gain calculation unit 140, according to one or more embodiments, will now be described based on an assumption that the input multi-channel signal is a two channel signal, such as a left signal and a right signal, noting that alternative embodiments are equally available.

First, the pre-processing unit 100 may select the left signal as a reference signal, and the transformation unit 110 may then generate a left spectrum and a right spectrum by transforming the left signal and the right signal from the time domain to the frequency domain by using a complex-valued transformation, as shown in the below Equation 5.

Equation 5:

$$L = a_k^L e^{i\varphi_k^L}$$
$$R = a_k^R e^{i\varphi_k^R}$$

Here, L denotes the left spectrum obtained by the transformation unit 110, R denotes L the right spectrum obtained by the transformation unit 110, $a_k^L$ denotes the amplitude of the left *spectrum*, $a_k^R$ denotes the amplitude of the right spectrum, $\varphi_k^L$ denotes the phase of the left spectrum, and $\varphi_k^R$ denotes the phase of the right spectrum.

The phase difference calculation unit 130 and the gain calculation unit 140 respectively calculate phase differences and gains that lead to a minimum value shown by the below Equation 6, for example.

Equation 6:

$$\min_{g,\psi} \sum_{k} \left[ a_k^R \cos\varphi_k^R - g a_k^L \cos(\varphi_k^L + \psi) \right]^2$$

Here, g denotes the gain and $\psi$ denotes the phase difference.

Then, Equation 6 may be partially differentiated with respect to the gain g and the phase difference $\psi$, as shown in the below Equation 7, for example.

Equation 7:

$$\frac{\partial}{\partial g} = \sum_k \left[ a_k^R \cos\varphi_k^R - g a_k^L \cos(\varphi_k^L + \psi) \right] a_k^L \cos(\varphi_k^L + \psi)$$

$$\frac{\partial}{\partial \psi} = \sum_k \left[ a_k^R \cos\varphi_k^R - g a_k^L \cos(\varphi_k^L + \psi) \right] a_k^L \sin(\varphi_k^L + \psi)$$

The phase difference calculation unit 130 and the gain calculation unit 140 finally, respectively calculate the phase difference $\psi$ and the gain g that cause values of Equation 7 to be zero by using the below Equation 8, for example, e.g., so that a mean squared error between a predicted right signal that is predicted by applying the gain g and the phase difference $\psi$ to the left signal which is the reference signal and the actual right signal are minimized.

Equation 8:

$$g = \frac{\sum_{k=1}^{m} a_k^R a_k^L \cos(\varphi_k^L + \psi) \cos\varphi_k^R}{\sum_{k=1}^{m} (a_k^L)^2 \cos^2(\varphi_k^L + \psi)}$$

$$g = \frac{\sum_{k=1}^{m} a_k^R a_k^L \sin(\varphi_k^L + \psi) \cos\varphi_k^R}{\sum_{k=1}^{m} (a_k^L)^2 \cos(\varphi_k^L + \psi) \sin(\varphi_k^L + \psi)}$$

The residual spectrum extraction unit 150 extracts residual spectrums corresponding to differences between the respective channel spectrums and predicted spectrums thereof, where the predicted spectrums are obtained by respectively applying the phase differences and gains of the respective channel spectrums calculated by the phase difference calculation unit 130 and the gain calculation unit 140 to the reference spectrum. For example, the residual spectrum extraction unit 150 may extract the residual spectrums according to the below Equation 9, for example.

Equation 9:

$$r_i = a_i \cos\varphi_i - \bar{s}_i$$

Here, $r_i$ denotes a residual spectrum corresponding to the $i^{th}$ channel *spectrum, a $_i$* denotes the actual amplitude of the $i^{th}$ channel spectrum, $\varphi_i$ denotes the phase of the $i^{th}$ channel spectrum, and $\overline{S}i$ denotes a real-number part of a predicted spectrum of the $i^{th}$ channel spectrum that is predicted by applying the phase difference and gain of the $i^{th}$ channel spectrum to the reference spectrum. The real-number part $S_i$ may be calculated as shown in the below Equation 10, for example.

Equation 10:

$$\overline{s}_i = Re\left\{ga_s \exp(\varphi_s + \psi)\right\}$$

Here, g denotes the gain calculated by the gain calculation unit 140, $\psi$ denotes the phase difference calculated by the phase difference calculation unit 130, $a_s$ denotes the amplitude of the reference spectrum, and $\varphi_s$ denotes the phase of the reference spectrum.

The phase difference quantization unit 135 may then quantize the phase differences between the respective channel spectrums and the reference spectrum, e.g., as calculated by the phase difference calculation unit 130. The phase difference quantization unit 135 may quantize the phase differences on a uniform scale, for example.

The gain quantization unit 145 may quantize the gains of the respective channel spectrums, e.g., as calculated by the gain calculation unit 140. The gain quantization unit 145 may quantize the gains of the respective channel spectrums on either a log scale or the uniform scale, as another example.

The residual spectrum quantization unit 155 may quantize the residual spectrums of the respective channel spectrums, e.g., as extracted by the residual spectrum extraction unit 150. The residual spectrum quantization unit 155 may quantize the residual spectrums by controlling an encoded amount of bits by determining quantization step size according to the psychoacoustic model, for example.

The operations of the pre-processing unit 100, the reference spectrum quantization unit 120, the phase difference calculation unit 130, the phase difference quantization unit 135, the gain calculation unit 140, the gain quantization unit 145, the residual spectrum extraction unit 150, and the residual spectrum quantization unit 155 may be performed in the units of bark bands in consideration of a critical band, for example, noting that alternative embodiments are equally available.

The prediction checking unit 160 may determine how precise, i.e., accurate, the predicted spectrums, obtained by the respectively applying of the phase differences and the gains calculated by the phase difference calculation unit 130 and the gain calculation unit 140 to the reference spectrum, have been predicted from the corresponding actual channel spectrums, e.g., the original spectrums.

The prediction checking unit 160 may determine the precision of the prediction by comparing the energies of the residual spectrums extracted by the residual spectrum extraction unit 150 with those of the respective actual channel spectrums, noting that alternative embodiments are equally available.

In addition, the prediction checking unit 160 may classify frames into several frame types based on the precision of the prediction and may respectively encode the residual spectrums adaptively according to the corresponding frame types. For example, the prediction checking unit 160 may classify frames into three frame types based on the precision of prediction, as shown in the below Equation 11, for example.

Equation 11:

$$first\ frame\ type: \frac{E_{res\_fr}}{E_{in\_fr}} < 0.25$$

$$sec\ ond\ frame\ type: 0.25 < \frac{E_{res\_fr}}{E_{in\_fr}} < 0.75$$

$$third\ frame\ type: \frac{E_{res\_fr}}{E_{in\_fr}} > 0.75$$

The frame types may be used as the context of entropy coding when the residual spectrums are encoded, for example.

Alternatively, a multi-channel encoding apparatus according to one or more embodiments may not include or implement the prediction checking unit 160, and the reference spectrum, phase differences, gains, and residual spectrums may be encoded regardless of the precision of prediction.

For example, when the ratio of the energy of one of the predicted spectrums to the energy of the corresponding actual channel spectrums, as calculated by the prediction checking unit 160, meets a threshold, e.g., is greater than the threshold, as illustrated in Equation 11 related to the third frame type, then the multi-channel quantization unit 170 may quantize the corresponding channel spectrums and set the gain and phase difference thereof to '0'. Thus, the gain and phase difference of the corresponding channel spectrums would not be respectively quantized by the phase difference quantization unit 135 and the gain quantization unit 145, since the predicated spectrum of the corresponding channel spectrum, e.g., as predicted by the applying of the phase difference and gain of the corresponding channel spectrum that are calculated by the phase difference calculation unit 130 and the gain calculation unit 140 to the reference spectrum, when the prediction is not accurate, and thus it may be more efficient to individually encode the corresponding channel spectrum.

The losslessly encoding unit 180 may losslessly code the reference spectrum quantized by reference spectrum quantization unit 120, the phase differences of the respective channel spectrums quantized by the phase difference quantization unit 135, the gains of the respective channel spectrums quantized by the gain quantization unit 145, and the residual spectrums quantized by the residual spectrum quantization unit 155. However, as noted, when the ratio of the energy of the predicted spectrum to the energy of an actual channel spectrum thereof in a bark band meets a threshold, e.g., is greater than the threshold, from among the channel spectrums, then the losslessly encoding unit 180 may losslessly code the corresponding channel spectrum instead of the phase differences, gains, and residual spectrums.

The multiplexing unit 190 may multiplex the reference spectrum, phase differences, gains, and residual spectrums, which are losslessly coded by the losslessly encoding unit 180, into a bitstream and then output the bitstream via an output terminal OUT. The multiplexing unit 190 may also multiplex the corresponding channel spectrum into a bitstream, instead of the phase differences, gains, and residual spectrums, according to the result of the prediction checking unit 160.

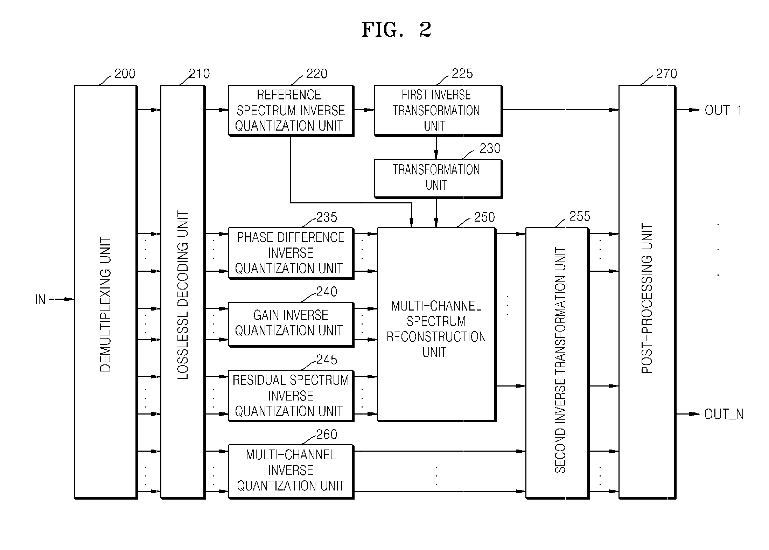

FIG. 2 illustrates a multi-channel decoding apparatus, according to one or more embodiments. Referring to FIG. 2, the multi-channel decoding apparatus may include a demultiplexing unit 200, a losslessly decoding unit 210, a reference spectrum inverse quantization unit 220, a first inverse transformation unit 225, a transformation unit 230, a phase difference inverse quantization unit 235, a gain inverse quantization unit 240, a residual spectrum inverse quantization unit 245, a multi-channel spectrum reconstruction unit 250, a second inverse transformation unit 255, a multi-channel inverse quantization unit 260, and a post-processing unit 270, for example. The losslessly decoding unit 210, the reference spectrum inverse quantization unit 220, the first inverse transformation unit 225, the transformation unit 230, the phase difference inverse quantization unit 235, the gain inverse quantization unit 240, the residual spectrum inverse quantization unit 245, the multi-channel spectrum reconstruction unit 250, the second inverse transformation unit 255, the multi-channel inverse quantization unit 260, and the post-processing unit 270 may be implemented or integrated as at least one processor or processing device, for example.

The demultiplexing unit 200 receives an encoded bitstream via an input terminal IN, and then demultiplexes the bitstream. The bitstream may include any of a reference spectrum, the phase differences between the respective channel spectrums and the reference spectrum, gains as ratios of amplitudes of the respective channel spectrums to an amplitude of the reference spectrum, and residual spectrums, or one or more channel spectrums, with respect to each of bark bands. Here, the reference spectrum may have been obtained by transforming a reference signal to be used as a reference for encoding from among N-channel signals. The residual spectrums correspond to the differences between the respective channel spectrums and predicted spectrums thereof, where the predicted spectrums had been predicted by respectively applying the phase differences and gains of the actual channel spectrums thereof to the reference spectrum.

The losslessly decoding unit 210 may losslessly decode either the reference spectrum, phase differences, gains, and residual spectrums or the one or more channel spectrums.

The reference spectrum inverse quantization unit 220 may inversely quantize the reference spectrum that has been losslessly decoded by the losslessly decoding unit 210.

The first inverse transformation unit 225 may derive the reference signal by performing a first inverse transformation on the inversely quantized reference spectrum from the frequency domain to the time domain. An example of the first inverse transformation may include IMDCT related to a real-number part during complex-valued transformation, for example.

However, since a one-frame delay may occur in the transformation unit 230, which will be described in greater detail below, the first inverse transformation unit 225 may delay the reference signal by one frame and then supply the reference signal to the post-processing unit 270.

The transformation unit 230 may perform a second transformation on the reference signal, e.g., as inversely transformed by the first inverse transformation unit 225, from the time domain to the frequency domain. An example of second transformation may include MDST, for example, related to an imaginary-number part during complex-valued transformation. Since the transformation unit 230 performs the second transformation on the reference signal after the first inversion transformation has been performed by the first inverse transformation unit 225, the reference signal is therefore delayed by one frame before output from the transformation unit 230.

The phase difference inverse quantization unit 235 may inversely quantize the phase difference of the respective channel spectrums decoded by the losslessly decoding unit 210. The phase difference inverse quantization unit 235 may inversely quantize the phase differences on a uniform scale, for example.

The gain inverse quantization unit 240 may inversely quantize the gains of the respective channel spectrums decoded by the losslessly decoding unit 210. The gain inverse quantization unit 240 may inversely quantize the gains on a log scale or the uniform scale, also as an example.

The residual spectrum inverse quantization unit 245 may inversely quantize the residual spectrums of the respective channel spectrums decoded by the losslessly decoding unit 210.

The multi-channel spectrum reconstruction unit 250 reconstructs the channel spectrums by applying the phase differences being inversely quantized by the phase difference inverse quantization unit 235, the gains being inversely quantized by the gain inverse quantization unit 240, and the residual spectrums being inversely quantized by the residual spectrum inverse quantization unit 245 to the reference spectrum. Here, the reference spectrum is inversely quantized by the reference spectrum inverse quantization unit 220 and is transformed by the transformation unit 230 so that it may be used to express all the amplitudes and phases of the respective channel signals. In other words, the multi-channel spectrum reconstruction unit 250 may reconstruct each of the channel spectrums by shifting the phase of the reference spectrum by the phase difference between the respective channel spectrums and the reference spectrum, adjusting the amplitude of the reference spectrum by the gain of the channel spectrum, and adding the corresponding residual spectrum to the reference spectrum.

However, as noted, a one-frame delay may occur in the transformation unit 230, and thus, the multi-channel spectrum reconstruction unit 250 may start to reconstruct the channel spectrums after a one-frame delay.

The second inverse transformation unit 255 may inversely transform the respective channel spectrums reconstructed by the multi-channel spectrum reconstruction unit 250 from the frequency domain to the time domain.

When a multi-channel encoding apparatus has previously determined that the then predicted spectrum of the at least one channel spectrum, predicted by an applying of a phase difference and gain of the at least one channel spectrum to the reference spectrum, was not accurately predicted, and thus had encoded the at least one channel spectrum instead of the phase differences, gains, and residual spectrums, then the multi-channel inverse quantization unit 260 may inversely quantize the corresponding at least one channel spectrum.

The second inverse transformation unit 255 may inversely transform the channel spectrums being inversely quantized by the multi-channel inverse quantization unit 260 from the frequency domain to the time domain.

The post-processing unit 270 may perform a post-processing operation on the reference signal, as inversely transformed by the first inverse transformation unit 225 and delayed by one frame, and the multi-channel signal, as inversely transformed by the second inverse transformation unit 255, and then output the multi-channel signal via an output terminal OUT. Here, the post-processing operation may be an inverse operation of an operation performed by the pre-processing unit 100 of FIG. 1, for example, noting that alternatives are equally available. For example, the post-processing unit 270 may reconstruct the multi-channel signal, by means of a reverse operation of a matrix operation applied to an encoding end.

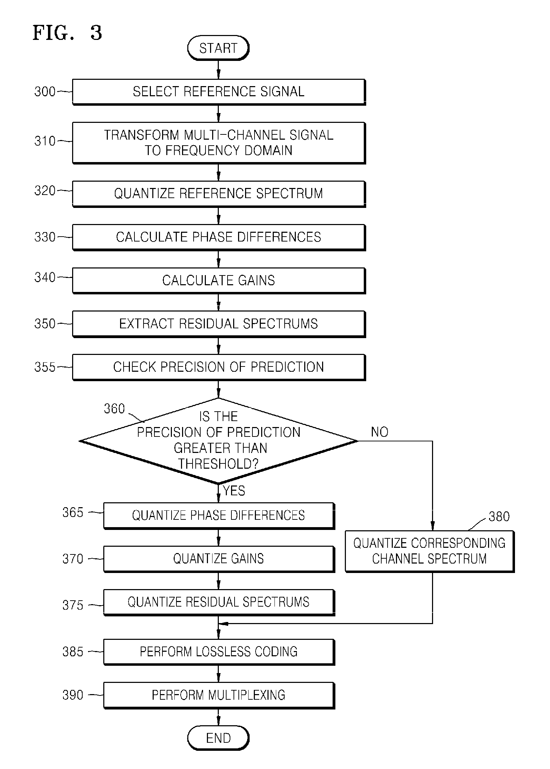

FIG. 3 illustrates a multi-channel encoding method, according to one or more embodiments.

First, a multi-channel signal having N-channel signals, may be received and a reference signal may be selected from among the N-channel signals (operation 300). Alternatively, in operation 300, the reference signal may be generated in various ways. For example, in operation 300, when the multi-channel signal includes two-channel signals, the reference signal may be selected or generated using the matrices expressed in the below Equation 12, for example. That is, if the multi-channel signal comprises the N-channel signals, the reference signal is generated or selected to minimize residual signals, by means of an operation of the N-channel signal and respective matrices.

Equation 12:

$$\begin{bmatrix} 1 & 0 \\ 0 & 1 \end{bmatrix}, \begin{bmatrix} 0 & 1 \\ 1 & 0 \end{bmatrix} and \begin{bmatrix} 1 & 1 \\ -1 & 1 \end{bmatrix}$$

Alternatively, in operation 300, the reference signal may be changed in units of bark bands from among the N-channel signals. If the number of channels included in the multi-channel signal increases or if necessary, a plurality of reference signals may be used.

In one or more embodiments, a multi-channel encoding method may alternatively not include or implement operation 300.

Next, multi-channel spectrums are generated by transforming the multi-channel signal from the time domain to the frequency domain so that amplitudes and phases of the respective channel signals are expressed (operation 310). For example, in operation 310, the respective multi-channel signals may be expressed in the form of complex-valued spectrums by performing a complex-valued transformation. When a complex-valued transformation is used in operation 310, a real-number part and imaginary part may be calculated by respectively performing MDCT and MDST, for example, on each of the channel signals in operation 310.

For example, in operation 310, when the multi-channel signal includes two-channel signals, such as a stereo signal, a left signal and a right signal may be transformed into x(t) and y(t) spectrums, as shown in the below Equation 13, for example.

Equation 13:

$$x(t) = a_0(t) e^{i\varphi_0(t)}$$
$$y(t) = a_1(t) e^{i\varphi_1(t)}$$

Here, x(t) denotes a spectrum being obtained by transforming the left signal (first channel signal) in operation 310, y(t) denotes a spectrum being obtained by transforming the right signal (second channel signal) in operation 310, $a_i(t)$ denotes the amplitude of an $i^{th}$ channel spectrum, and $\varphi_i(t)$ denotes the phase of the $i^{th}$ channel spectrum.

Next, the transformed reference spectrum may be quantized (operation 320). When a complex-valued transformation is performed using MDCT and MDST, for example, in operation 310, then only the reference spectrum obtained by performing MDCT may be quantized in operation 320. Alternatively, in operation 320, the reference spectrum may be quantized by controlling an encoded amount of bits by determining the quantization step size according to a psychoacoustic model.

Next, the phase differences between the respective channel spectrums and the reference spectrum may be calculated (operation 330). For example, in operation 330, the phase differences may be calculated as shown in the below Equation 14, for example.

Equation 14:

$$\psi_i = \varphi_s(t) - \varphi_i(t)$$

Here, $\psi_i$ denotes the difference between phases of the $i^{th}$ channel spectrum and the reference spectrum, $\varphi_s(t)$ denotes the phase of the reference spectrum, and $\varphi_i(t)$ denotes the phase of the $i^{th}$ channel spectrum.

Next, gains as ratios of amplitudes of the respective channel spectrums to the amplitude of the reference spectrum may be calculated (operation 340). For example, in operation 340, the gains may be calculated as shown in the below Equation 15, for example.

Equation 15:

$$g_i = \frac{a_s}{a_1}$$

Here, $g_i$ denotes the gain of the $i^{th}$ channel spectrum, $a_s$ denotes the amplitude of the reference spectrum, and $a_i$ denotes the amplitude of the $i^{th}$ channel spectrum.

A corresponding process for calculating the phase differences between the respective channel spectrums and the reference spectrum in operation 330 and process for calculating the gains of the respective channel spectrums in operation 340, according to one or more embodiments, will now be described based on an assumption that the input multi-channel signal includes a left signal and a right signal received via two channels, noting that alternative embodiments are equally available.

First, in operation 300, as only an example, the left signal may be selected as a reference signal in operation 300. Next, in operation 310, a left spectrum and a right spectrum are generated by respectively transforming the left and right signals from the time domain to the frequency domain by performing a complex-valued transformation, as shown in the below Equation 16, for example.

Equation 16:

$$L = a_k^{\mathrm{L}} e^{i\varphi_k^{\mathrm{L}}}$$
$$R = a_k^{\mathrm{R}} e^{i\varphi_k^{\mathrm{R}}}$$

Here, L denotes the left spectrum obtained in operation 310, R denotes the right spectrum obtained in operation 310, $a_k^{L}$ denotes the amplitude of the left spectrum, $a_k^{R}$ denotes the amplitude of the right spectrum, $\varphi_k^{L}$ denotes the phase of the left spectrum, and $\varphi_k^{R}$ denotes the phase of the right spectrum.

In operations 330 and 340, the phase difference between the left and right spectrums and a gain as a ratio of the amplitude of the right spectrum to the amplitude of the left spectrum, can lead to the minimum value shown in the below Equation 17, for example.

Equation 17:

$$\min_{g,\psi} \sum_k \left[ a_k^R \cos\varphi_k^R - g a_k^L \cos(\varphi_k^L + \psi) \right]^2$$

Here, g denotes the gain and $\psi$ denotes the phase difference.

Equation 17 may be partially differentiated with respect to the gain g and the phase difference $\psi$, as shown in the below Equation 18, for example.

Equation 18:

$$\frac{\partial}{\partial g} = \sum_k \left[ a_k^R \cos\varphi_k^R - g a_k^L \cos(\varphi_k^L + \psi) \right] a_k^L \cos(\varphi_k^L + \psi)$$

$$\frac{\partial}{\partial \psi} = \sum_k \left[ a_k^R \cos\varphi_k^R - g a_k^L \cos(\varphi_k^L + \psi) \right] a_k^L \sin(\varphi_k^L + \psi)$$

In operations 330 and 340, the phase difference $\psi$ and the gain g that cause values of Equation 18 to be zero may be calculated using the below Equation 19, for example, e.g., so that a mean squared error between a predicted right signal that is predicted by applying the gain g and the phase difference $\psi$ to the left signal, which is the reference signal, and the actual right signal are minimized.

Equation 19:

$$g = \frac{\sum_{k=1}^{m} a_k^R a_k^L \cos(\varphi_k^L + \psi) \cos\varphi_k^R}{\sum_{k=1}^{m} (a_k^L)^2 \cos^2(\varphi_k^L + \psi)}$$

$$g = \frac{\sum_{k=1}^{m} a_k^R a_k^L \sin(\varphi_k^L + \psi) \cos\varphi_k^R}{\sum_{k=1}^{m} (a_k^L)^2 \cos(\varphi_k^L + \psi) \sin(\varphi_k^L + \psi)}$$

Next, residual spectrums corresponding to differences between the respective channel spectrums and predicted spectrums thereof may be extracted (operation 350), where the predicted spectrums are obtained by respectively applying the phase differences and the gains of the respective channel spectrums calculated in operations 330 and 340 to the reference spectrum. For example, the residual spectrums may be extracted using the below Equation 20, for example.

Equation 20:

$$r_i = a_i \cos\varphi_i - \bar{s}_i$$

Here, $r_i$ denotes a residual spectrum corresponding to the ith channel spectrum, $a_i$ denotes the actual amplitude of the ith channel spectrum, $\varphi_i$ denotes the phase of the ith channel spectrum, and $\bar{S}_i$ denotes a real-number part of a predicted spectrum of the ith channel spectrum that is predicted by applying the phase difference and gain of the ith channel spectrum to the reference spectrum. The real-number part $\bar{S}_i$ may be calculated as shown in the below Equation 21, for example.

Equation 21:

$$\bar{s}_i = Re\{ga_s \exp(\varphi_s + \psi)\}$$

Here, g denotes the gain of the ith channel spectrum calculated in operation 340, $\psi$ denotes the phase difference between the ith channel spectrum and the reference spectrum, which is calculated in operation 330, $a_s$ denotes the amplitude of the reference spectrum, and $\varphi_s$ denotes the phase of the reference spectrum.

Next, a determination may be made as to how precise the predicted spectrums, e.g., which are obtained by respectively applying the phase differences and the gains calculated in operations 330 and 340 to the reference spectrum, have been predicted from the corresponding actual channel spectrums (operation 355).

In operation 355, the precision of prediction of the predicted spectrums may be determined by comparing the energies of the residual spectrums extracted in operation 350 with the energies of the respective actual channel spectrums for example, noting that alternative embodiments are equally available.

In addition, in operation 355, frames may be classified into several frame types based on the determined precision of prediction, and the residual spectrums may be respectively encoded adaptively according to the frame types. For example, in operation 355, frames may be classified into three frame types based on the precision of prediction, as shown in the below Equation 22, for example.

Equation 22:

$$first\ frame\ type : \frac{E_{res\_fr}}{E_{in\_fr}} < 0.25$$

$$sec ond\ frame\ type : 0.25 < \frac{E_{res\_fr}}{E_{in\_fr}} < 0.75$$

$$third\ frame\ type : \frac{E_{res\_fr}}{E_{in\_fr}} > 0.75$$

Further, the frame types may be used as the context of entropy coding when the residual spectrums are encoded, for example.

Next, it is determined whether the precision of prediction determined in operation 355 meets a threshold, e.g., is greater than the threshold (operation 360).

In one or more embodiments, when it is determined in operation 360 that the precision of prediction is greater than the threshold, the phase differences between the respective channel spectrums and the reference spectrum calculated in operation 330 are quantized (operation 335). In operation 335, the phase differences may be quantized on a uniform scale, for example.

Next, the gains of the respective channel spectrums calculated in operation 340 may be quantized (operation 370). In operation 370, the gains may be quantized on a log scale or the uniform scale, for example.

Next, the residual spectrums extracted in operation 350 may be quantized (operation 375). In operation 375, the residual spectrums may be quantized while controlling an encoded amount of bits by determining the quantization step size according to a psychoacoustic model.

Operations 300, 320, 330, 340, 350, 365, 370 and 375 may be processed in the units of bark bands in consideration of a critical band, for example.

When it is determined in operation 360 that the precision of the prediction of the predicted spectrum is less than the threshold, for example, the channel spectrum corresponding to the predicted spectrum may be quantized and the gain and phase difference of the corresponding channel spectrum may be set to '0' (operation 380). This is because the predicted spectrum that is obtained by applying the phase difference and gain of the corresponding channel spectrum, e.g., as calculated in operations 330 and 340, to the reference spectrum may be considered to not be accurately predicted, and thus it is more efficient to individually encode the corresponding channel spectrum.

Next, either the reference spectrum quantized in operation 320, the phase differences between the respective channel spectrums and the reference spectrum quantized in operation 365, the gains of the respective channel spectrums quantized in operation 370, and the residual spectrums quantized in operation 375 are losslessly coded, or the at least one channel spectrum is losslessly coded (operation 385).

Next, any of the reference spectrum, phase differences, gains, and residual spectrums or the channel spectrums that are losslessly coded in operation 385 are multiplexed into a bitstream (operation 390).

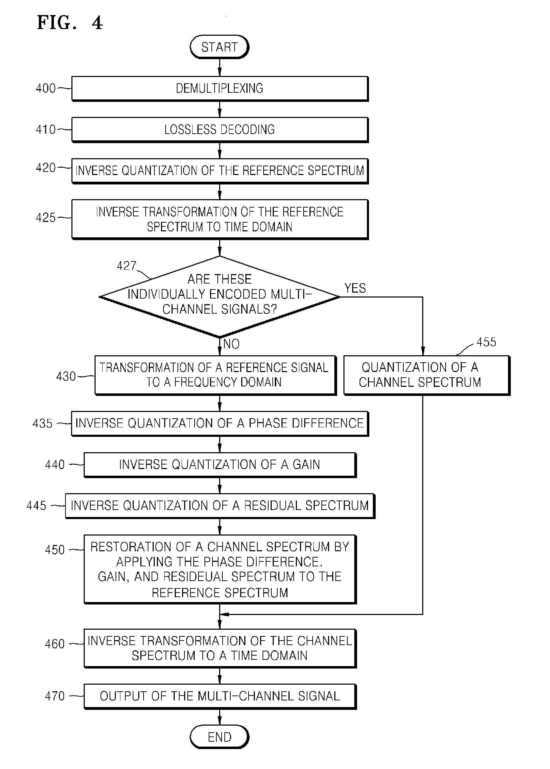

FIG. 4 illustrates a multi-channel decoding method, according to one or more embodiments.

First, a received bitstream may be demultiplexed. The bitstream may include any of a reference spectrum, the phase differences between the reference spectrum and respective channel spectrums, gains as ratios of amplitudes of the respective channel spectrums and an amplitude of the reference spectrum, and residual spectrums or at least one channel spectrum, with respect to each of bark bands (in operation 400). Here, the reference spectrum may have been obtained by transforming a reference signal that was selected, e.g., from N-channel signals, as a reference for the corresponding encoding of the N-channel signals. The residual spectrums correspond to differences between respective channel spectrums and predicted spectrums thereof, where each of the predicted spectrums would have been predicted by an applying of the calculated phase difference and gain of the actual channel spectrum thereof to the selected reference spectrum.

Next, any of the reference spectrum, phase differences, gains, and residual spectrums, or the at least one channel spectrum may be losslessly decoded (operation 410).

Next, the losslessly decoded reference spectrum may be inversely quantized (operation 420).

Next, the reference signal may be generated by performing a first inverse transformation on the inversely quantized reference spectrum from the frequency domain to the time domain (operation 425). An example of the first inverse transformation may include IMDCT, for example, in which a real-number part is calculated during complex-valued transformation.

Next, it may be determined as to whether at least one channel signal in the multi-channel signal has been individually encoded, e.g., because a precision of prediction was determined to be low during the corresponding multi-channel encoding with regard to the at least one channel signal (operation 427).

When it is determined in operation 427 that at least one channel signal in the multi-channel signal has not been individually encoded, then the reference signal being inversely transformed in operation 425 may be transformed from the time domain to the frequency domain by performing a second transformation (operation 430). An example of second transformation includes MDST, for example, related to an imaginary-number part during complex-valued transformation. However, as noted above, since the reference signal is inversely transformed using the first inverse transformation in operation 425 and then transformed again using the second transformation in operation 430, the reference signal may be delayed by one frame before output.

Next, the phase differences decoded in operation 410 may be inversely quantized (operation 435). In operation 435, the phase differences may be inversely quantized on a uniform scale, for example.

Next, the gains of the respective channel spectrums decoded in operation 410 may be inversely quantized (operation 440). In operation 440, the gains may be inversely quantized on a log scale or the uniform scale, for example.

Next, the residual spectrums of the respective channel spectrums decoded in operation 410 may be inversely quantized (operation 445).

Thereafter, the respective channel spectrums may be reconstructed by applying the phase differences as inversely quantized in operation 435, the gains as inversely quantized in operation 440, and the residual spectrums as inversely quantized in operation 445, to the reference spectrum (operation 450). Here, the reference spectrum may be inversely quantized in operation 420 and transformed in operation 430 so that it may be used to express all the amplitudes and phases of the respective N-channel signals. In other words, in operation 450, each of the respective channel spectrums may be reconstructed by shifting the phase of the reference spectrum by the phase difference between the respective channel spectrums and the reference spectrum, adjusting the amplitude of the reference spectrum according to the gain of the channel spectrum, and adding the corresponding residual spectrum to the reference spectrum. However, a one-frame delay occurs in operation 430, and thus, operation 450 may be performed after a one-frame delay.

Next, the respective channel spectrums reconstructed in operation 450 may be inversely transformed from the frequency domain to the time domain (operation 460).

When it is determined in operation 427 that at least one channel signal in the multi-channel signal has been individually encoded, then the at least one channel spectrum is inversely quantized, e.g., where the at least one channel spectrum has been encoded instead of the phase differences, gains, and residual spectrums since, during an encoding of the at least one channel signal, the encoder calculated predicted spectrum of the at least one channel spectrum, e.g., predicted by applying the phase difference and gain of the at least one channel spectrum to the reference spectrum, was determined to not be accurately predicted (operation 455).

Next, the multi-channel signal may be generated by inversely transforming either the channel spectrums reconstructed in operation 450 or the at least one channel spectrum being inversely quantized in operation 455 from the frequency domain to the time domain (operation 460).

Next, the multi-channel signal may be output by performing a post-processing operation on the reference spectrum as inversely transformed in operation 420 and the multi-channel signal as inversely transformed in operation 460, where the post-processing operation may be an inverse operation of an operation performed in operation 300 of FIG. 3 (operation 470), as only an example. When it is determined in operation 427 that at least one channel signal in the multi-channel signal has not been is individually encoded, then operation 470 may be performed on the reference signal that is inversely transformed and delayed by one frame in operation 425 and the multi-channel signal being inversely transformed in operation 460. When it is determined in operation 427 that at least one channel signal in the multi-channel signal has not been individually encoded, then operation 470 may be performed after the one-frame delay.

In one or more embodiments, signals are described as data expressed in the time domain and spectrums are described as data expressed in the frequency domain in the present disclosure, but signals are generally considered as including spectrums.

One or more embodiments may be implemented through computer readable code/instructions in/on a medium, e.g., a computer readable medium, to control at least one processing element to implement any above described embodiment. The medium can correspond to any defined, measurable, and tangible structure permitting the storing and/or transmission of the computer readable code.

The media may also include, e.g., in combination with the computer readable code, data files, data structures, and the like. Examples of the media include magnetic media such as hard disks, floppy disks, and magnetic tape; optical media such as CD ROM disks and DVDs; magneto-optical media such as optical disks; and hardware devices that are specially configured to store and perform program instructions, such as read-only memory (ROM), random access memory (RAM), flash memory, and the like. Examples of computer readable code include both machine code, such as produced by a compiler, and files containing higher level code that may be executed by the computer using an interpreter, for example. The media may also be a distributed network, so that the computer readable code is stored and executed in a distributed fashion. Still further, as only an example, the processing element could include a processor or a computer processor, and processing elements may be distributed and/or included in a single device.

While aspects of the present invention has been particularly shown and described with reference to differing embodiments thereof, it should be understood that these exemplary embodiments should be considered in a descriptive sense only and not for purposes of limitation. Descriptions of features or aspects within each embodiment should typically be considered as available for other similar features or aspects in the remaining embodiments.

Thus, although a few embodiments have been shown and described, with additional embodiments being equally available, it would be appreciated by those skilled in the art that changes may be made in these embodiments without departing from the principles and spirit of the invention, the scope of which is defined in the claims and their equivalents.

**Claims**

1. A multi-channel encoding apparatus comprising:

   a reference signal encoding unit to select a reference signal from among a plurality of channel signals in a multi-channel signal and to encode the reference signal;
   a phase difference encoding unit to calculate and encode respective phase differences between a remainder of the plurality of channel signals and the reference signal;
   a gain encoding unit to calculate and encode respective gains of the remainder of the plurality of channel signals, with the respective gains being ratios of respective amplitudes of the remainder of the plurality of channel signals to an amplitude of the reference signal; and
   a residual signal encoding unit to extract and encode respective residual signals corresponding to differences between each predicted signal and each corresponding channel signal of the remainder of the plurality of channel signals, where each predicted signal is predicted by respectively applying a respective calculated phase difference and a respective calculated gain to the reference signal for each corresponding channel signal of the remainder of the plurality of channel signals.

2. The multi-channel encoding apparatus of claim 1, wherein the reference signal encoding unit generates the reference signal to minimize the residual signals by means of a matrix operation between the plurality of channel signals and the reference signal.

3. The multi-channel encoding apparatus of claim 1, further comprising a transformation unit to respectively transform the remainder of the plurality of channel signals to express the respective amplitudes and phases of the remainder of the plurality of channel signals.

4. The multi-channel encoding apparatus of claim 3, wherein the transformation unit transforms the multi-channel signal by performing a complex-valued transformation.

5. The multi-channel encoding apparatus of claim 3, wherein the transformation unit transforms the remainder of the plurality of channel signals by performing a modified discrete cosine transformation (MDCT) and modified discrete sine transformation (MDST).

6. The multi-channel encoding apparatus of claim 1, wherein the phase difference encoding unit and the gain encoding unit respectively calculate the respective phase differences and respective gains so as to lead to a minimum mean squared error between each predicted signal and each corresponding channel signal of the remainder of the plurality of channel signals.

7. The multi-channel encoding apparatus of claim 1, wherein the phase difference encoding unit, the gain encoding unit, and the residual signal encoding unit perform encoding in units of bark bands in consideration of a critical band.

8. The multi-channel encoding apparatus of claim 1, further comprising:

   a prediction checking unit perform a determination of a respective precision of each predicted signal; and
   a multi-channel encoding unit to selectively individually encode at least one channel signal, of the remainder of the plurality of channel signals, based on the determined respective precision of each predicted signal as meeting a threshold.

9.   The multi-channel encoding apparatus of claim 8, wherein, when the multi-channel encoding unit individually encodes the at least one channel signal, the multi-channel encoding unit sets the phase difference and gain of the at least one channel signal to zero.

10.   The multi-channel encoding apparatus of claim 8, wherein the prediction checking unit determines the respective precision of each predicted signal by comparing energies of each predicted signal with respective energies of residual signals thereof.

11.   The multi-channel encoding apparatus of claim 8, wherein the residual signal encoding unit encodes the respective residual signals adaptively according to the determined respective precision of each predicted signal.

12.   A multi-channel decoding apparatus comprising:

     a reference signal decoding unit to decode a reference signal, from among a plurality of channel signals, for a multi-channel signal;
     a phase difference decoding unit to decode respective phase differences between remainder channel signals of the plurality of channel signals and the reference signal, with the remainder of the plurality of channel signals including the plurality of channel signals without the reference signal;
     a gain decoding unit to decode respective gains of the remainder of the plurality of channel signals as ratios of respective amplitudes of the remainder of the plurality of channel signals to an amplitude of the reference signal;
     a residual signal decoding unit to decode respective residual signals corresponding to encoder determined differences between each predicted signal and each corresponding channel signal of the remainder of the plurality of channel signals, with each predicted signal being predicted by respectively applying an encoder calculated phase difference and an encoder calculated gain to the reference signal during an encoding of the multi-channel signal; and
     a multi-channel reconstruction unit to reconstruct the remainder of the plurality of channel signals by using the respective phase differences, respective gains, and respective residual signals.

13.   The multi-channel decoding apparatus of claim 12, wherein the multi-channel reconstruction unit reconstructs the multi-channel signal, by means of a reverse operation of a matrix operation applied to an encoding end.

14.   The multi-channel decoding apparatus of claim 12, wherein the multi-channel reconstruction unit reconstructs the remainder of the plurality of channel signals by respectively shifting a phase of the reference signal by the respective decoded phase differences, adjusting the amplitude of the reference signal by the respective decoded gains, and respectively adding the residual signals to the reference signal.

15.   The multi-channel decoding apparatus of claim 12, further comprising:

     an inverse transformation unit to inversely transform the decoded reference signal from a frequency domain to a time domain; and
     a transformation unit to transform the inversely transformed reference signal from the time domain to the frequency domain.

16.   The multi-channel decoding apparatus of claim 15, wherein the inverse transformation unit inversely transforms the decoded reference signal by performing an inverse modified discrete cosine transformation (IMDCT), and the transformation unit transforms the inversely transformed reference signal by performing a modified discrete sine transformation (MDST).

17.   The multi-channel decoding apparatus of claim 15, wherein the multi-channel reconstruction unit performs reconstruction based on a one-frame delay.

18.   The multi-channel decoding apparatus of claim 12, further comprising a multi-channel decoding unit to decode an individually encoded channel of the multi-channel signal, the individually encoded channel having been encoded based on a precision of a corresponding predicted signal being determined to be low during the encoding of the multi-channel signal.

19.   The multi-channel decoding apparatus of claim 12, wherein the phase difference decoding unit, the gain decoding unit, and the residual signal decoding unit perform decoding in units of bark bands in consideration of a critical band.

**20.** The multi-channel decoding apparatus of claim 12, wherein the residual signal decoding unit respectively decodes the residual signals adaptively according to encoder determined respective precisions of prediction of each predicted signal.

**21.** A multi-channel encoding method comprising:

selecting and encoding a reference signal from among a plurality of channel signals in a multi-channel signal;
calculating and encoding respective phase differences between a remainder of the plurality of channel signals and the reference signal;
calculating and encoding respective gains of the remainder of the plurality of channel signals, with the respective gains being ratios of respective amplitudes of the remainder of the plurality of channel signals to an amplitude of the reference signal; and
extracting and encoding respective residual signals corresponding to differences between each predicted signal and each corresponding channel signal of the remainder of the plurality of channel signals, where each predicted signal is predicted by respectively applying a respective calculated phase difference and a respective calculated gain to the reference signal for each corresponding channel signal of the remainder of the plurality of channel signals.

**22.** The multi-channel encoding method of claim 21, further comprising respectively transforming the remainder of the plurality of channel signals to express the respective amplitudes and phases of the remainder of the plurality of channel signals.

**23.** The multi-channel encoding method of claim 22, wherein the transforming of the channel signals comprises transforming the channel signals by performing a complex-valued transformation.

**24.** The multi-channel encoding method of claim 22, wherein the transforming of the channel signals comprises transforming the channel signals by performing a modified discrete cosine transformation (MDCT) and a modified discrete sine transformation (MDST).

**25.** The multi-channel encoding method of claim 21, wherein, the encoding of the respective phase differences and the encoding of the respective gains respectively calculate the respective phase differences and respective gains so as to lead to a minimum mean squared error between each predicted signal and each corresponding channel signal of the remainder of the plurality of channel signals.

**26.** The multi-channel encoding method of claim 21, wherein the encoding of the respective phase differences, the encoding of the respective gains, and the encoding of the respective residual signals are performed in units of bark bands in consideration of a critical band.

**27.** The multi-channel encoding method of claim 21, further comprising:

determining a respective precision of each predicted signal; and
selectively individually encoding at least one channel signal, of the remainder of the plurality of channel signals, based on the determined respective precision of each predicted signal as meeting a threshold.

**28.** The multi-channel encoding method of claim 27, wherein the selectively individually encoding of the channel signal comprises setting the phase difference and gain of the at least one channel signal to zero.

**29.** The multi-channel encoding method of claim 27, wherein the determining of the respective precision of each predicted signal comprises determining the respective precision of each predicted signal by comparing energies each predicted signal with respective energies of residual signals thereof.

**30.** The multi-channel encoding method of claim 27, wherein the encoding of the residual signals comprises respectively encoding the residual signals adaptively according to the determined respective precision of each predicted signal.

**31.** A multi-channel decoding method comprising:

decoding a reference signal, from among a plurality of channel signals, for a multi-channel signal;
decoding respective phase differences between remainder channel signals of the plurality of channel signals and the reference signal;

decoding respective gains of the remainder of the plurality of channel signals as ratios of respective amplitudes of the remainder of the plurality of channel signals to an amplitude of the reference signal;

decoding respective residual signals corresponding to encoder determined differences between each predicted signal and each corresponding channel signal of the remainder of the plurality of channel signals, with each predicted signal being predicted by respectively applying a calculated phase difference and a calculated gain to the reference signal during an encoding of the multi-channel signal; and

reconstructing the remainder of the plurality of channel signals by using the respective phase differences, respective gains, and respective residual signals.

32. The multi-channel decoding method of claim 31, wherein the reconstructing of the remainder of the plurality of channel signals comprises reconstructing the remainder of the plurality of channel signals by respectively shifting a phase of the reference signal by the respective decoded phase differences, adjusting the amplitude of the reference signal by the respective decoded gains, and respectively adding the residual signals to the reference signal.

33. The multi-channel decoding method of claim 31, further comprising:

inversely transforming the decoded reference signal from a frequency domain to a time domain; and
transforming the inversely transformed reference signal from the time domain to the frequency domain.

34. The multi-channel decoding method of claim 33, wherein the inversely transforming of the decoded reference signal comprises inversely transforming the decoded reference signal by performing an inverse modified discrete cosine transformation (IMDCT), and

the transforming of the inversely transformed reference signal comprises transforming the inversely transformed reference signal by performing a modified discrete sine transformation (MDST).

35. The multi-channel decoding method of claim 31, further comprising decoding an individually encoded channel of the multi-channel signal, the individually encoded channel having been encoded based on a precision of a corresponding predicted signal being determined to be low during the encoding of the multi-channel signal.

36. The multi-channel decoding method of claim 31, wherein the decoding of the respective phase differences, the decoding of the respective gains and the decoding of the respective residual signals are performed in units of bark bands in consideration of a critical band.

37. The multi-channel decoding method of claim 31, wherein the decoding of the respective residual signals comprises respectively decoding the residual signals adaptively according to encoder determined respective precisions of prediction of each predicted signal.

38. A computer readable recording medium having recorded thereon a computer program to control at least one processing device to implement a multi-channel encoding method, the method comprising:

selecting and encoding a reference signal from among a plurality of channel signals in a multi-channel signal;
calculating and encoding respective phase differences between a remainder of the plurality of channel signals and the reference signal;
calculating and encoding respective gains of the remainder of the plurality of channel signals, with the respective gains being ratios of respective amplitudes of the remainder of the plurality of channel signals to an amplitude of the reference signal; and
extracting and encoding respective residual signals corresponding to differences between each predicted signal and each corresponding channel signal of the remainder of the plurality of channel signals, where each predicted signal is predicted by respectively applying a respective calculated phase difference and a respective calculated gain to the reference signal for each corresponding channel signal of the remainder of the plurality of channel signals.

39. A computer readable recording medium having recorded thereon a computer program to control at least one processing device to implement a multi-channel decoding method, the method comprising:

decoding a reference signal, from among a plurality of channel signals, for a multi-channel signal;
decoding respective phase differences between remainder channel signals of the plurality of channel signals and the reference signal;

decoding respective gains of the remainder of the plurality of channel signals as ratios of respective amplitudes of the remainder of the plurality of channel signals to an amplitude of the reference signal;

decoding respective residual signals corresponding to encoder determined differences between each predicted signal and each corresponding channel signal of the remainder of the plurality of channel signals, with each predicted signal being predicted by respectively applying an encoder calculated phase difference and an encoder calculated gain to the reference signal during an encoding of the multi-channel signal; and

reconstructing the remainder of the plurality of channel signals by using the respective phase differences, respective gains, and respective residual signals.

**FIG. 1**

FIG. 2

FIG. 3

START

300 — SELECT REFERENCE SIGNAL

310 — TRANSFORM MULTI-CHANNEL SIGNAL TO FREQUENCY DOMAIN

320 — QUANTIZE REFERENCE SPECTRUM

330 — CALCULATE PHASE DIFFERENCES

340 — CALCULATE GAINS

350 — EXTRACT RESIDUAL SPECTRUMS

355 — CHECK PRECISION OF PREDICTION

360 — IS THE PRECISION OF PREDICTION GREATER THAN THRESHOLD?

NO

YES

365 — QUANTIZE PHASE DIFFERENCES

370 — QUANTIZE GAINS

375 — QUANTIZE RESIDUAL SPECTRUMS

380 — QUANTIZE CORRESPONDING CHANNEL SPECTRUM

385 — PERFORM LOSSLESS CODING

390 — PERFORM MULTIPLEXING

END

## FIG. 4

START

400 — DEMULTIPLEXING

410 — LOSSLESS DECODING

420 — INVERSE QUANTIZATION OF THE REFERENCE SPECTRUM

425 — INVERSE TRANSFORMATION OF THE REFERENCE SPECTRUM TO TIME DOMAIN

427 — ARE THESE INDIVIDUALLY ENCODED MULTI-CHANNEL SIGNALS? — YES

NO

430 — TRANSFORMATION OF A REFERENCE SIGNAL TO A FREQUENCY DOMAIN

455 — QUANTIZATION OF A CHANNEL SPECTRUM

435 — INVERSE QUANTIZATION OF A PHASE DIFFERENCE

440 — INVERSE QUANTIZATION OF A GAIN

445 — INVERSE QUANTIZATION OF A RESIDUAL SPECTRUM

450 — RESTORATION OF A CHANNEL SPECTRUM BY APPLYING THE PHASE DIFFERENCE. GAIN, AND RESIDEUAL SPECTRUM TO THE REFERENCE SPECTRUM

460 — INVERSE TRANSFORMATION OF THE CHANNEL SPECTRUM TO A TIME DOMAIN

470 — OUTPUT OF THE MULTI-CHANNEL SIGNAL

END